# EUROPÄISCHE PATENTANMELDUNG

(11) **EP 4 088 838 A1**
(43) Veröffentlichungstag der Anmeldung: **16.11.2022**
(21) Anmeldenummer: 21173485.0
(22) Anmeldetag: 12.05.2021
(51) Int. Cl.: B22F 1/00, B22F 9/24

(54) **VERFAHREN ZUR HERSTELLUNG VON SILBERPULVER**

(71) Anmelder: Heraeus Deutschland GmbH & Co. KG, 63450 Hanau (DE)
(72) Erfinder: DR. MAIER, Dirk, 63450 Hanau (DE)
(74) Vertreter: Heraeus IP

(57) **Zusammenfassung**

Verfahren zur Herstellung von Silberpartikeln durch Umsetzung von Silbernitrat mit Ascorbinsäure, umfassend die aufeinander folgenden Schritte:
(1) Vorlegen und Rühren einer auf einen pH-Wert von 8 bis 10 eingestellten wässrigen Lösung, welche 2 bis 4 Gew.-% Stärke und 1,7 bis 5,5 % der im Verfahren insgesamt eingesetzten Ascorbinsäure umfasst,
(2) gleichzeitiges separates Zudosieren einer wässrigen Silbernitratlösung und einer wässrigen Ascorbinsäurelösung in die gerührte Vorlage aus Schritt (1),
(3) Hydrolyse der Stärke unter Ausbildung einer wässrigen Suspension von Silberpartikeln, und
(4) Abtrennen der Silberpartikel aus der wässrigen Suspension,
wobei 1,7 bis 2 mol Silbernitrat pro mol Ascorbinsäure eingesetzt werden.

## Beschreibung

Die Erfindung betrifft ein Verfahren zur Herstellung von Silberpulver durch Reaktion von Silbernitrat mit Ascorbinsäure.

In Colloids and Surfaces B: Biointerfaces 102 (2013), Seiten 578 - 584 berichten Khan et al. über Silbernanopartikel und deren Herstellung aus wässriger Silbernitratlösung und wässriger Ascorbinsäurelösung in Gegenwart von Stärke.

Aufgabe der vorliegenden Erfindung war es, ein Verfahren zur Herstellung von Silberpulver mit einer durchschnittlichen Teilchengröße d50 im Submikron- bis wenige Mikrometer-Bereich und mit monomodaler und enger Teilchengrößenverteilung zu finden.

Der hierin verwendete Begriff "durchschnittliche Teilchengröße d50" bezieht sich auf den mittleren Primärteilchendurchmesser, im hiesigen Kontext auf den mittleren Primärteilchendurchmesser von Silberpartikeln. Diese durchschnittliche Teilchengröße d50 (parallel damit auch die d10- und d90-Werte) kann aus einer elektronenmikroskopischen Aufnahme eines betreffenden Silberpulvers mittels Bildauswertungssoftware durch Bildanalyse einer aussagekräftigen statistisch relevanten Anzahl von Silberpartikeln bestimmt werden. Hierbei können mindestens fünf Sekundärelektronenbilder mittels Rasterelektronenmikroskop bei 3000-facher sowie bei 8000-facher Vergrößerung aufgenommen und die Partikeldurchmesser mittels einer Bildbearbeitungssoftware vermessen und als Partikelgrößenverteilung dargestellt werden; beispielsweise kann das am U.S. National Institutes of Health entwickelte Programm "NIH Image" verwendet werden (siehe http://rsb.info.nih.gov/nih-image/).

Die Aufgabe ist erfindungsgemäß lösbar mittels eines Verfahrens zur Herstellung von Silberpartikeln durch Umsetzung von Silbernitrat mit Ascorbinsäure, umfassend die aufeinander folgenden Schritte:
(1) Vorlegen und Rühren einer auf einen pH-Wert von 8 bis 10 eingestellten wässrigen Lösung, welche 2 bis 4 Gew.-% (Gewichts-%) Stärke und 1,7 bis 5,5 % der im Verfahren insgesamt eingesetzten Ascorbinsäure umfasst,
(2) gleichzeitiges separates Zudosieren einer wässrigen Silbernitratlösung und einer wässrigen Ascorbinsäurelösung in die gerührte Vorlage aus Schritt (1),
(3) Hydrolyse der Stärke unter Ausbildung einer wässrigen Suspension von Silberpartikeln, und
(4) Abtrennen der Silberpartikel aus der wässrigen Suspension,
wobei 1,7 bis 2 mol Silbernitrat pro mol Ascorbinsäure eingesetzt werden.

In Schritt (1) des erfindungsgemäßen Verfahrens wird eine auf einen pH-Wert im Bereich von 8 bis 10, bevorzugt von 8 bis 9,5 eingestellte wässrige 2 bis 4gew.-%ige Stärkelösung vorgelegt und gerührt, wobei die wässrige Stärkelösung ferner 1,7 bis 5,5 % der im erfindungsgemäßen Verfahren insgesamt eingesetzten Ascorbinsäure umfasst.

Die wässrige Stärkelösung gemäß Schritt (1) umfasst wässrig gelöste Stärke in einem Mengenanteil im Bereich von 2 bis 4 Gew.-%. Die wässrig gelöste Stärke dient dabei als Verdickungsmittel. Bei der wässrig gelösten Stärke handelt es sich um in Wasser gelöste lösliche Stärke. Der Begriff "lösliche Stärke" bezeichnet in warmem bis heißem Wasser lösliche Stärke. Lösliche Stärke hat die CAS-Nr.: 9005-84-9; sie ist im Handel erhältlich, beispielsweise von Merck unter der Bezeichnung "Stärke löslich".

Wässrige Stärkelösung kann durch Lösen von löslicher Stärke in warmem Wasser hergestellt werden, beispielsweise durch Einrühren von löslicher Stärke in kaltes Wasser und anschließendes kurzes, beispielsweise 20 bis 60 minütiges Erhitzen auf eine Temperatur beispielsweise im Bereich von 85 bis 90 °C und anschließendes beispielsweise 10 bis 20 minütiges Halten bei 85 bis 90°C, gefolgt von zügigem Abkühlen auf unter 50 °C.

Nach oder bei Herstellung einer wässrigen Stärkelösung gewünschter Konzentration innerhalb des Bereichs von 2 bis 4 Gew.-% können darin 1,7 bis 5,5 % der im erfindungsgemäßen Verfahren insgesamt eingesetzten Ascorbinsäure gelöst oder in Form wässriger Ascorbinsäurelösung zugegeben werden. Ferner kann der pH-Wert im Bereich von 8 bis 10, bevorzugt von 8 bis 9,5 durch Zugabe von Base, beispielsweise in Form wässriger Alkalihydroxid- und/oder Ammoniumhydroxidlösung, eingestellt werden. Im Ergebnis erhält man eine wässrige Stärkelösung, die neben den Hauptbestandteilen Wasser und 2 bis 4 Gew.-% wässrig gelöste Stärke 1,7 bis 5,5 % der im erfindungsgemäßen Verfahren insgesamt eingesetzten Ascorbinsäure und ferner Base in einem Mengenanteil aufweist, welcher einen pH-Wert der wässrigen Stärkelösung im Bereich von 8 bis 10, bevorzugt von 8 bis 9,5 bewirkt. Für den Fachmann bedarf es keiner Erläuterung, dass die Ascorbinsäure bei einem pH-Wert in diesem Bereich als Ascorbat vorliegt.

Die vorstehend beschriebene Zugabereihenfolge von Wasser, löslicher Stärke, Ascorbinsäure und Base bei der Zubereitung der wässrigen Stärkelösung kann beliebig variiert werden. Zweckmäßig ist jedoch die Zugabereihenfolge: Wasser, lösliche Stärke, Ascorbinsäure, Base.

Die wässrige Stärkelösung gemäß Schritt (1) wird vorgelegt und gerührt. Das Rühren dieser Vorlage kann beispielsweise bei einer Temperatur von 20 bis 25°C erfolgen.

Vor Durchführung von Schritt (2) werden eine wässrige Silbernitratlösung und eine wässrige Ascorbinsäurelösung durch Lösen von Silbernitrat respektive von Ascorbinsäure in Wasser zubereitet. Die wässrige Silbernitratlösung umfasst Silbernitrat, zweckmäßig in einem Mengenanteil von 25 bis 32 Gew.-%. Die wässrige Ascorbinsäurelösung umfasst Ascorbinsäure, zweckmäßig in einem Mengenanteil von 22 bis 29 Gew.-%.

In Schritt (2) werden die wässrige Silbernitratlösung und die wässrige Ascorbinsäurelösung gleichzeitig und separat in die gerührte Vorlage aus Schritt (1) zudosiert.

Die Summe der Volumina der wässrigen Silbernitratlösung und der wässrigen Ascorbinsäurelösung kann beispielsweise in einem Volumenverhältnis im Bereich von 1 : 1 bis 1 : 1,2 zum Volumen der gerührten Vorlage aus Schritt (1) stehen.

Die wässrige Silbernitratlösung und die wässrige Ascorbinsäurelösung werden separat voneinander zudosiert, d.h. die beiden Zudosierstellen in die gerührte Vorlage aus Schritt (1) sind voneinander getrennt, bevorzugt mit großem bis größtmöglichem Abstand.

Das separate Zudosieren der wässrigen Silbernitratlösung und der wässrigen Ascorbinsäurelösung erfolgt gleichzeitig und dabei beispielsweise über einen Zeitraum von mindestens 10 Minuten bis 4 Stunden, bevorzugt 30 Minuten bis 4 Stunden. Gleichzeitiges Zudosieren bedeutet, dass das Zudosieren der beiden Lösungen parallel ohne oder mit nur geringem zeitlichem Abstand von beispielsweise bis zu 30 Sekunden beginnt und parallel ohne oder mit nur geringem zeitlichem Abstand von beispielsweise bis zu 15 Minuten endet. Bevorzugt erfolgt der Beginn des separaten Zudosierens der beiden wässrigen Lösungen zeitgleich. Das eigentliche Zudosieren beider wässriger Lösungen kann in kleinen Portionen und dabei entweder zeitgleich oder alternierend erfolgen; bevorzugt erfolgt das eigentliche Zudosieren jeweils kontinuierlich.

Das Zudosieren gemäß Schritt (2) erfolgt in die gerührte Vorlage aus Schritt (1). Das Rühren kann mit verschiedenen Rührvorrichtungen bewirkt werden, beispielsweise mittels eines Impeller- oder Propellerrührers. Zweckmäßig kann beim Rühren mindestens ein Stromstörer eingesetzt werden und/oder das Rührorgan kann in außerzentrischer Anordnung in einem zylindrischen Rührgefäß eingesetzt werden. Es kann zweckmäßig sein, in einem Rührgefäß mit einem Durchmesser-/Füllhöhenverhältnis von 0,8 bis 1,2 zu arbeiten. Bevorzugt erfolgt das Rühren unter Sicherstellung einer Makromischzeit beispielsweise im Bereich von 1 bis 2 Sekunden. Die Makromischzeit ist die Zeit, die benötigt wird, um eine zu einer im Rührgefäß vorgelegten und gerührten Flüssigkeit A zugegebene geringe flüssige Stoffmenge B zu mindestens 90% zu homogenisieren. Die Bestimmung der Makromischzeit kann im vorliegenden Fall beispielsweise in einem separaten einfachen Versuch durch Zutropfen einer lod/Kaliumiodid-Lösung (Lugolsche Lösung) zu einer im Rührgefäß vorgelegten Stärkelösung erfolgen, indem die sich unmittelbar bildende farbige Spur eines jeweiligen Tropfens bis zu ihrem "Verschwinden" visuell verfolgt und die dabei verstreichende Zeit bestimmt wird; mit anderen Worten, bei einer vorgegebenen gewünschten Makromischzeit lässt sich so auch ein geeignetes "Rührdesign" erarbeiten, umfassend Auswahl von Rührgefäß, Rührer, Rührgeschwindigkeit, Zudosierweise etc.

Im erfindungsgemäßen Verfahren werden 1,7 bis 2 mol Silbernitrat pro mol Ascorbinsäure eingesetzt; dabei sind sowohl der Ascorbinsäureanteil in der gerührten Vorlage aus Schritt (1) als auch der Ascorbinsäureanteil in der in Schritt (2) zudosierten wässrigen Ascorbinsäurelösung zu berücksichtigen. Letzterer macht dementsprechend 94,5 bis 98,3 % der im erfindungsgemäßen Verfahren insgesamt eingesetzten Ascorbinsäure aus.

Während Schritt (2) kann die Temperatur des Rührguts zweckmäßig beispielsweise im Bereich von 20 bis 28°C gehalten werden.

Der zu Beginn der Zudosierung im Bereich von 8 bis 10, bevorzugt von 8 bis 9,5 liegende pH-Wert fällt mit fortschreitender Zudosierung in den sauren pH-Bereich ab, beispielsweise in einen pH-Bereich von 0,5 bis 1. Es kann zweckmäßig sein, während Schritt (2), beispielsweise wenn eine pH-Wert-Absenkung um 0,5 bis 1,5 pH-Einheiten erreicht ist, eine plötzliche unterstützende pH-Wertsenkung im Rührgut auf pH < 2, beispielsweise 0,5 bis < 2 durch Säurezugabe, insbesondere Salpetersäurezugabe zu bewirken.

Nach Beendigung der Zudosierung kann noch kurz, beispielsweise 10 Minuten weiter gerührt werden.

Im Anschluss an Schritt (2) erfolgt in Schritt (3) eine Hydrolyse der Stärke. Dabei werden die Stärkemoleküle in ebenfalls wasserlösliche kleinere Moleküle zerlegt, insbesondere in Maltose. Diese an sich bekannte Hydrolyse kann nach einer pH-Anhebung auf einen Wert beispielsweise im Bereich von 5 bis 7 enzymatisch geschehen durch Zugabe einer oder mehrerer verschiedener Amylasen in das Rührgut und weiteres Rühren, beispielsweise 0,5 bis 2 Stunden bei 50 bis 75°C. Alternativ kann die Stärkehydrolyse ohne pH-Anhebung nichtenzymatisch durch Erwärmen des Rührguts erfolgen, beispielsweise während 0,5 bis 2 Stunden bei 50 bis 60°C.

Im Zuge der respektive nach Beendigung der Stärkehydrolyse beobachtet man die Aufhebung der verdickenden Wirkung der Stärke, mit anderen Worten, das Rührgut wird dünnflüssiger und zeigt dann eine Viskosität angenähert der von Wasser. Im Ergebnis bildet sich eine wässrige Suspension von Silberpartikeln. Neben den Silberpartikeln umfasst die wässrige Suspension eine wässrige Lösung als flüssige Phase. Neben den Hydrolyseprodukten der Stärke umfasst die wässrige Lösung Oxidationsprodukte der Ascorbinsäure, Salpetersäure respektive Nitrat, Alkali- und/oder Ammoniumionen sowie gegebenenfalls stöchiometrisch überschüssige, unverbrauchte Ascorbinsäure.

In Schritt (4) werden die Silberpartikel aus der wässrigen Suspension abgetrennt. Das Abtrennen kann mittels üblicher Fest-Flüssig-Trennmethoden wie beispielsweise Filtrieren, Zentrifugieren oder Dekantieren erfolgen, und die so abgetrennten Silberpartikel können gewaschen und getrocknet werden. Üblicherweise wird Wasser als Waschmedium verwendet.

Unmittelbares Verfahrensprodukt ist ein Silberpulver aus Silberpartikeln mit einer durchschnittlichen Teilchengröße d50 im Bereich von 500 nm bis 3 µm mit monomodaler enger Teilchengrößenverteilung. Die d10-Werte liegen dabei beispielsweise im Bereich von 200 bis 1000 nm und die d90-Werte beispielsweise im Bereich von 2 bis 6 µm.

Mittels des erfindungsgemäßen Verfahrens erhältliches Silberpulver zeichnet sich ferner durch eine Stampfdichte beispielsweise im Bereich von 4 bis 6 g/cm³ und eine spezifische Oberfläche (BET-Oberfläche) beispielsweise im Bereich von 0,2 bis 0,5 m²/g aus. Die Stampfdichte kann gemäß DIN EN ISO 787-11 bestimmt werden. Die spezifische Oberfläche kann mittels BET-Messung gemäß DIN ISO 9277 (statisch-volumetrisches Messverfahren, verwendetes Gas: Stickstoff) bestimmt werden. Bei den hier zitierten Normen handelt es sich jeweils um deren aktuelle Fassung zum Zeitpunkt des prioritätsbegründenden Anmeldetages.

Mittels des erfindungsgemäßen Verfahrens herstellbares Silberpulver ist besonders geeignet zur Verwendung als Bestandteil von Silberpasten wie sie beispielsweise zur Herstellung von Leiterbahnen und Elektroden in der Elektronik und in der Photovoltaik Verwendung finden. Die besondere Eignung zur Verwendung in diesen Bereichen resultiert aus der vorstehend erläuterten Teilchengrößenverteilung; so kann mittels des erfindungsgemäßen Verfahrens herstellbares Silberpulver in diesen Anwendungsbereichen vorteilhafterweise direkt verwendet werden, d.h. ohne weiterer Klassierungsmaßnahmen zu bedürfen. Gegebenenfalls kann das Silberpulver, je nach Einsatzzweck, mit einer üblichen dem Fachmann bekannten Beschichtung, einem sogenannten Coating, versehen werden.

### Beispiele

Beispiel 1 (Herstellung von 65 g Silberpulver mit monomodaler Partikelgrößenverteilung mit d10 = 900 nm, d50 = 1,5 um und d90 = 3µm): Verwendet wurde ein Becherglas mit einem Durchmesser von 100 mm mit einem 8 mm Abstand zur Wandung aufweisenden zylindrischen Glasstab mit 6 mm Durchmesser als Stromstörer. Der Glasstab tauchte ein bis 5 mm über der Rührblattoberkante eines dreiflügeligen Impellerrührers mit 60 mm Durchmesser und 10 mm Abstand zum Boden des Becherglases. In dieser Apparatur wurden 11,7 g Stärke löslich (Merck) in 392 ml deionisiertem Wasser suspendiert, dann unter Rühren innerhalb 60 Minuten auf 85°C erhitzt und anschließend 10 Minuten bei 85°C weiter gerührt. Die gebildete klare Lösung wurde dann rasch im Wasserbad abgekühlt.

Es wurden zwei separate Lösungen hergestellt: 150 ml 28gew.-%ige wässrige Silbernitratlösung und 217,6 ml 25gew.-%ige wässrige Ascorbinsäurelösung.

Zur mit 200 U/min gerührten Stärkelösung wurden bei 22 °C 7,6 ml der Ascorbinsäurelösung hinzugegeben. Der pH-Wert betrug danach 2,85 und wurde durch Zugabe von 5gew.%-iger Natronlauge auf 9,4 eingestellt.

Anschließend wurden gleichzeitig beginnend die Silbernitratlösung mit 1,25 ml/min und die restliche Ascorbinsäurelösung mit 1,6 ml/min jeweils an gegenüberliegenden Punkten mit 10 mm Abstand zur Becherglaswand über Schlauchpumpen zugetropft.

Es bildete sich eine Silberpulversuspension, die für 1 Stunde bei 50 °C gerührt wurde. Anschließend wurde das Rühren beendet. Das Silberpulver setzte sich ab und die überstehende Lösung wurde abdekantiert. Danach wurde mit 500 ml Wasser aufgefüllt und für 20 Minuten gerührt und das Waschwasser mittels Zentrifuge abgetrennt.

Der Waschprozess wurde dreimal wiederholt und das feuchte Silberpulver bei 100 °C im Trockenschrank getrocknet.

Beispiel 2 (Herstellung von 65 g Silberpulver mit monomodaler Partikelgrößenverteilung mit d10 = 1,5 um, d50 = 2,5 um und d90 = 5,5 um): Verwendet wurde ein Becherglas mit einem Durchmesser von 100 mm mit einem 8 mm Abstand zur Wandung aufweisenden zylindrischen Glasstab mit 6 mm Durchmesser als Stromstörer. Der Glasstab tauchte ein bis 5 mm über der Rührblattoberkante eines dreiflügeligen Impellerrührers mit 60 mm Durchmesser und 10 mm Abstand zum Boden des Becherglases. In dieser Apparatur wurden 11,7 g Stärke löslich (Merck) in 392 ml deionisiertem Wasser suspendiert, dann unter Rühren innerhalb 60 Minuten auf 85°C erhitzt und anschließend 10 Minuten bei 85 °C weiter gerührt. Die gebildete klare Lösung wurde dann rasch im Wasserbad abgekühlt.

Es wurden zwei separate Lösungen hergestellt: 150 ml 28gew.-%ige wässrige Silbernitratlösung und 217,6 ml 25gew.-%ige wässrige Ascorbinsäurelösung.

Zur mit 200 U/min gerührten Stärkelösung wurden bei 22 °C 7,6 ml der Ascorbinsäurelösung hinzugegeben. Der pH-Wert betrug danach 2,85 und wurde durch Zugabe von 5gew.%-iger Natronlauge auf 8,9 eingestellt.

Anschließend wurden gleichzeitig beginnend die Silbernitratlösung mit 1,25 ml/min und die restliche Ascorbinsäurelösung mit 1,6 ml/min jeweils an gegenüberliegenden Punkten mit 10 mm Abstand zur Becherglaswand über Schlauchpumpen zugetropft.

Es bildete sich eine Silberpulversuspension, die durch Zugabe von Natronlauge auf einen pH-Wert von 5,5 eingestellt und auf 65 °C erhitzt wurde, wonach 0,5 g Alpha-Amylase und 0,5 g Beta-Amylase hinzugegeben und für 1 Stunde gerührt wurde. Anschließend wurde das Rühren beendet. Das Silberpulver setzte sich ab und die überstehende Lösung wurde abdekantiert. Danach wurde mit 500 ml Wasser aufgefüllt und für 20 Minuten gerührt und das Waschwasser mittels Zentrifuge abgetrennt.

Der Waschprozess wurde dreimal wiederholt und das feuchte Silberpulver bei 100 °C im Trockenschrank getrocknet.

Beispiel 3 (Herstellung von 90 kg Silberpulver mit monomodaler Partikelgrößenverteilung mit d10 = 900 nm, d50 = 1,5 um und d90 = 3,5 um): Verwendet wurde ein emaillierter Reaktor mit einem Durchmesser von 1250 mm ausgestattet mit einem 200 mm außerzentrisch positionierten dreiflügeligen Propellerrührer mit 270 mm Durchmesser und 160 mm Bodenabstand. In diesem Reaktor wurden 16 kg Stärke löslich (Merck) in 542 I deionisiertem Wasser suspendiert, dann unter Rühren innerhalb 60 Minuten auf 90°C erhitzt und anschließend 10 Minuten bei 90°C weiter gerührt. Die gebildete klare Lösung wurde dann rasch abgekühlt.

Es wurden zwei separate Lösungen hergestellt: 208 I wässrige 28gew.-%ige Silbernitratlösung und 302 I 25gew.-%ige wässrige Ascorbinsäurelösung.

Zur mit 350 U/min gerührten Stärkelösung wurden bei 22 °C 10,6 I der Ascorbinsäurelösung hinzugegeben. Der pH-Wert betrug danach 2,85 und wurde durch Zugabe von 5gew.%-iger Natronlauge auf 9,4 eingestellt.

Anschließend wurden gleichzeitig beginnend die Silbernitratlösung mit 1,73 l/min und die restliche Ascorbinsäurelösung mit 2,21 l/min jeweils an gegenüberliegenden Punkten mit 100 mm Abstand zur Reaktorwand über Schlauchpumpen zudosiert.

Es bildete sich eine Silberpulversuspension, die für 1 Stunde bei 50 °C gerührt wurde. Anschließend wurde das Rühren beendet. Das Silberpulver setzte sich ab und die überstehende Lösung wurde abdekantiert. Danach wurde mit 700 I Wasser aufgefüllt und für 20 Minuten gerührt und das Waschwasser mittels Zentrifuge abgetrennt.

Der Waschprozess wurde dreimal wiederholt und das feuchte Silberpulver bei 100 °C im Trockenschrank getrocknet.

## Patentansprüche

1. Verfahren zur Herstellung von Silberpartikeln durch Umsetzung von Silbernitrat mit Ascorbinsäure, umfassend die aufeinander folgenden Schritte:
(1) Vorlegen und Rühren einer auf einen pH-Wert von 8 bis 10 eingestellten wässrigen Lösung, welche 2 bis 4 Gew.-% Stärke und 1,7 bis 5,5 % der im Verfahren insgesamt eingesetzten Ascorbinsäure umfasst,
(2) gleichzeitiges separates Zudosieren einer wässrigen Silbernitratlösung und einer wässrigen Ascorbinsäurelösung in die gerührte Vorlage aus Schritt (1),
(3) Hydrolyse der Stärke unter Ausbildung einer wässrigen Suspension von Silberpartikeln, und
(4) Abtrennen der Silberpartikel aus der wässrigen Suspension,
wobei 1,7 bis 2 mol Silbernitrat pro mol Ascorbinsäure eingesetzt werden.

2. Verfahren nach Anspruch 1, wobei die Vorlage aus Schritt (1) bei einer Temperatur von 20 bis 25°C gerührt wird.

3. Verfahren nach Anspruch 1 oder 2, wobei die wässrige Silbernitratlösung 25 bis 32 Gew.-% Silbernitrat und die wässrige Ascorbinsäurelösung 22 bis 29 Gew.-% Ascorbinsäure umfasst.

4. Verfahren nach einem der vorhergehenden Ansprüche, wobei die Summe der Volumina der wässrigen Silbernitratlösung und der wässrigen Ascorbinsäurelösung in einem Volumenverhältnis im Bereich von 1 : 1 bis 1 : 1,2 zum Volumen der gerührten Vorlage aus Schritt (1) steht.

5. Verfahren nach einem der vorhergehenden Ansprüche, wobei das separate Zudosieren der wässrigen Silbernitratlösung und der wässrigen Ascorbinsäurelösung über einen Zeitraum von mindestens 10 Minuten bis 4 Stunden erfolgt.

6. Verfahren nach einem der vorhergehenden Ansprüche, wobei das Rühren unter Sicherstellung einer Makromischzeit im Bereich von 1 bis 2 Sekunden erfolgt.

7. Verfahren nach einem der vorhergehenden Ansprüche, wobei die Temperatur des Rührguts während Schritt (2) im Bereich von 20 bis 28°C gehalten wird.

8. Verfahren nach einem der vorhergehenden Ansprüche, wobei man während Schritt (2), wenn eine pH-Wert-Absenkung um 0,5 bis 1,5 pH-Einheiten erreicht ist, eine plötzliche pH-Wertsenkung im Rührgut auf pH < 2 durch Säurezugabe bewirkt.

9. Verfahren nach einem der vorhergehenden Ansprüche, wobei die Hydrolyse der Stärke nach einer pH-Anhebung auf einen Wert im Bereich von 5 bis 7 enzymatisch oder ohne pH-Anhebung nichtenzymatisch geschieht.

10. Verfahren nach einem der vorhergehenden Ansprüche, wobei Schritt (4) ein Waschen und Trocknen der aus der wässrigen Suspension abgetrennten Silberpartikel umfasst.

11. Nach einem Verfahren eines der vorhergehenden Ansprüche herstellbare Silberpartikel.

12. Ein Silberpulver bildende Silberpartikel nach Anspruch 11 mit einer durchschnittlichen Teilchengröße d50 im Bereich von 500 nm bis 3 µm mit monomodaler enger Teilchengrößenverteilung.

13. Silberpulver nach Anspruch 12 mit einem d10-Wert im Bereich von 200 bis 1000 nm und einem d90-Wert im Bereich von 2 bis 6 µm.

14. Ohne Anwendung von Klassierungsmaßnahmen erhältliches Silberpulver nach Anspruch 12 oder 13.

15. Verwendung von Silberpulver nach einem der Ansprüche 12 bis 14 als Bestandteil von Silberpasten.
